# EUROPÄISCHE PATENTSCHRIFT

(11) **EP 2 436 051 B1**
(45) Veröffentlichungstag und Bekanntmachung des Hinweises auf die Patenterteilung: **01.07.2015**
(21) Anmeldenummer: 10721022.1
(22) Anmeldetag: 19.05.2010
(51) Int. Cl.: H01L 41/083

(54) **PIEZOELEKTRISCHES BAUELEMENT**
PIEZOELECTRIC COMPONENT
COMPOSANT PIÉZOÉLECTRIQUE

(30) Priorität: 29.05.2009 DE 102009023356; 28.09.2009 DE 102009043220
(43) Veröffentlichungstag der Anmeldung: 04.04.2012
(73) Patentinhaber: Epcos AG, 81669 München (DE)
(72) Erfinder: DERNOVSEK, Oliver, A-8501 Lieboch (AT); GLAZUNOV, Alexander, A-8530 Deutschlandsberg (AT)
(74) Vertreter: Epping - Hermann - Fischer
(86) Internationale Anmeldenummer: PCT/EP2010/056912
(87) Internationale Veröffentlichungsnummer: WO 2010/136367

(56) Entgegenhaltungen:
- WO-A1-2008/138906
- DE-A1- 10 201 641
- DE-A1-102005 052 686

## Beschreibung

Es wird ein piezoelektrisches Bauelement mit piezoelektrischen Schichten angegeben.

Piezoelektrische Bauelemente wie etwa vielschichtige piezoelektrische Aktoren bestehen aus mehreren Schichten eines piezoelektrischen Materials mit Innenelektroden zwischen den piezoelektrischen Schichten. Üblicherweise wird im ganzen Aktor das gleiche piezoelektrische Material verwendet. Piezoelektrische Aktoren verfügen weiterhin über eine Vielzahl von übereinander angeordneten, mit abwechselnder elektrischer Polarität kontaktierten Innenelektroden, zwischen denen sich das piezoelektrische Material je nach angelegter Spannung an den Innenelektroden verformen kann. Um die Innenelektroden einfach kontaktieren zu können, werden üblicherweise in einem so genannten inaktiven Bereich nur jeweils der gleichen elektrischen Polarität zugeordnete Innenelektroden angeordnet. Die der anderen elektrischen Polarität zugeordneten Innenelektroden erstrecken sich an dieser Stelle nicht bis ganz zum Rand des Aktors, sondern sind auf eine Fläche im Innern des Aktors begrenzt. Daher findet im inaktiven Bereich beim Anlegen einer elektrischen Spannung fast keine Ausdehnung des piezoelektrischen Materials statt, was im Randgebiet des inaktiven Bereichs zu einer Zugbelastung durch die Dehnung im aktiven Bereich führt. Abhängig von der Anzahl der piezoelektrische Schichten und der angelegten elektrischen Spannung steigen somit auch die am Rand des inaktiven Bereichs auftretenden Zugspannungen.

Die Zuverlässigkeit eines vielschichtigen piezoelektrischen Aktors hängt entscheidend von der Beherrschung eventuell auftretender Risse ab. Bei den laminationsthermischen Prozessen wie Sintern bei maximalen Temperaturen von 800 bis 1500°C, Metallisieren und Löten sowie bei der Polarisation entstehen aufgrund der oben beschriebenen unterschiedlichen Dehnung im aktiven (angesteuerten) und inaktiven (isolierenden) Bereich elastische Spannungen, die zu so genannten Entlastungsrissen und/oder Polungsrissen führen. Diese können im inaktiven Bereich oder auch entlang einer Elektrodenschicht laufen. Beim Übergang in den aktiven Bereich können die Risse unkontrolliert abknicken. Wenn ein Riss dabei mindestens zwei Elektroden überbrückt, können Kurzschlüsse entstehen, was zum Versagen des piezoelektrischen Aktors führt.

Aus der DE 102 34 787 C1 und der DE 103 07 825 A1 sind piezoelektrische Aktoren bekannt, bei denen poröse Strukturen vorgesehen sind, die eine geringere Festigkeit als die übrigen piezoelektrischen Schichten aufweisen. Die erhöhte Porosität wird erzeugt durch Verwendung eines erhöhten Anteils eines organischen Binders in diesen Bereichen im Vergleich zum Bindergehalt in den übrigen piezoelektrischen Schichten. Weitere Beispiele sind in DE 102005052686 und DE 10201641 zu finden.

Zumindest eine Aufgabe von bestimmten Ausführungsformen ist es, ein piezoelektrisches Bauelement anzugeben, das eine unkontrollierte Rissbildung vermeidet oder zumindest vermindert.

Diese Aufgabe wird durch einen Gegenstand mit den Merkmalen des unabhängigen Patentanspruchs 1 gelöst. Vorteilhafte Ausführungsformen und Weiterbildungen des Gegenstands sind in den abhängigen Ansprüchen gekennzeichnet und gehen weiterhin aus der nachfolgenden Beschreibung und den Zeichnungen hervor.

Ein piezoelektrisches Bauelement umfasst insbesondere einen Stapel aus übereinander angeordneten piezoelektrischen Schichten und dazwischen angeordneten ersten und zweiten Elektrodenschichten, wobei der Stapel zumindest eine erste piezoelektrische Schicht mit einer ersten elektrischen Koerzitivfeldstärke und direkt dazu benachbart eine zweite piezoelektrische Schicht mit einer zweiten elektrischen Koerzitivfeldstärke verschieden von der ersten Koerzitivfeldstärke aufweist.

Insbesondere kann das piezoelektrische Bauelement als Piezoaktor in Vielschichtbauweise ausgebildet sein.

Das piezoelektrische Bauelement umfasst direkt zueinander benachbarte piezoelektrische Schichten mit unterschiedlichen Koerzitivfeldstärken. Die Koerzitivfeldstärke bestimmt, wie gut das piezoelektrische Material beim Anlegen eines elektrischen Feldes mit vorgegebener Stärke gepolt wird, und damit unter anderem auch, wie groß die elastische Dehnung und Spannung im Material sein werden. Wenn zwei Materialien mit unterschiedlichen Koerzitivfeldstärken miteinander in Kontakt gebracht werden, kann an ihrer Kontaktgrenze ein Unterschied an elastischen Spannungen während der Polarisation entsteht, welcher die Bildung von Entlastungs- und/oder Polungsrissen an der Kontaktgrenze zwischen beiden Materialien fördern kann. Hier und im Folgenden wird dabei unter der Koerzitivfeldstärke einer Schicht des Stapels aus piezoelektrischen Schichten die elektrische Koerzitivfeldstärke der Schicht verstanden.

Bei dem hier beschriebenen piezoelektrischen Bauelement ist es somit mit Vorteil möglich, eine Stelle, wo die Entlastungs- und/oder Polungsrisse entstehen, und anschließend den Verlauf der Risse im Wesentlichen parallel zu den Elektrodenschichten vorzugeben, um so ein unkontrolliertes Wachstum quer zu den Elektrodenschichten zu verhindern oder zumindest zu verringern. Im Gegensatz zu Entlastungs- und/oder Polungsrissen, die mindestens zwei Elektrodenschichten überbrücken, stellen Risse, die parallel oder zumindest im Wesentlichen parallel zu den Innenelektroden verlaufen, dagegen beinahe keine Gefahr für Lebensdauer von Aktoren dar. Dies gilt umso mehr, als dass für das hier beschriebene piezoelektrische Bauelement die erste und zweite piezoelektrische Schicht jeweils derart gewählt sind, dass eine Kontaktgrenze zwischen den beiden Schichten einen Bereich zur Bildung von Entlastungs- und/oder Polungsrissen bildet, die parallel oder zumindest im Wesentlichen parallel zu den Elektrodenschichten verlaufen. Dabei bedeutet "im Wesentlichen parallel" hier und im Folgenden, dass die Entlastungs- und/oder Polungsrisse zwar nicht zwingend vollständig geradlinig und im mathematischen Sinne parallel, aber dennoch mit einer Haupterstreckungsrichtung entlang der Elektrodenschichten verlaufen und dabei keinen Verlauf aufweisen, durch den zwei Elektrodenschichten überbrücken werden können.

Durch die erste und zweite piezoelektrische Schicht mit unterschiedlichen Koerzitivfeldstärken können beispielsweise bei thermischen Behandlungen, beim Metallisieren, beim Löten, beim Polungsprozess und/oder im Betrieb des piezoelektrischen Bauelements lokale elastische Spannungen im Stapel des piezoelektrischen Bauelements erzeugt werden, die zur gezielten Rissbildung führen sollen. Durch die definiert eingebrachte zumindest eine erste und eine zweite piezoelektrische Schicht können unterschiedliche Polarisationszustände etwa während des Polungsprozesses an der Kontaktgrenze zwischen der ersten und zweiten piezoelektrischen Schicht zu Polungsrissen führen. Die Polungsrisse verlaufen parallel oder im Wesentlichen parallel zu den Elektrodenschichten. So wird ein unkontrolliertes Risswachstum quer zu den Elektrodenschichten verhindert, ohne dass etwa aus dem Stand der Technik bekannte poröse Strukturen in das piezoelektrische Bauelement eingebracht werden müssen.

Die erste und die zweite piezoelektrische Schicht können dadurch unterschiedliche Koerzitivfeldstärken aufweisen, dass sie sich in ihrer Zusammensetzung unterscheiden, was insbesondere bedeuten kann, dass sie unterschiedliche Keramikmaterialen, unterschiedliche Dotierstoffe, unterschiedliche Dotierstoffkonzentrationen oder unterschiedliche Partikelgrößen von jeweils verwendeten Ausgangsmaterialien aufweisen. Weiterhin können die erste und zweite piezoelektrische Schichte unterschiedliche Schichtdicken aufweisen. Um die erste und zweite piezoelektrische Schicht mit unterschiedlichen Koerzitivfeldstärken herzustellen, können diese sich in genau einer der vorgenannten Eigenschaften oder auch in mehreren der vorgenannten Eigenschaften unterscheiden. Dabei kann es nach Erkenntnis der Erfinder vorteilhaft hinsichtlich der Prozessierbarkeit und der Wirtschaftlichkeit des Herstellungsprozesses sein, wenn sich die erste und zweite piezoelektrische Schicht in genau einer oder nur wenigen der vorgenannten Eigenschaften unterschieden. Je größer die Anzahl der die erste und zweite piezoelektrische Schicht unterscheidenden Eigenschaften ist, desto größer kann hingegen aber auch mit Vorteil der Freiheitsgrad in der Herstellung der ersten elektrischen Koerzitivfeldstärke im Vergleich zur zweiten elektrischen Koerzitivfeldstärke sein.

Die erste und zweite piezoelektrische Schicht können jeweils ein Keramikmaterial aufweisen, das jeweils aus mehreren Bestandteilen gebildet ist, die mit gewissen jeweiligen Konzentrationen vorliegen. Die erste und zweite piezoelektrische Schicht können sich dabei in der Konzentration zumindest eines Bestandteils unterscheiden. Beispielsweise kann die erste piezoelektrische Schicht ein bleihaltiges Keramikmaterial, etwa basierend auf Blei-Zirkon-Titanat (PZT) aufweisen, während die zweite piezoelektrische Schicht ein bleiloses Keramikmaterial aufweist. Alternativ dazu können auch die erste und zweite piezoelektrische Schicht jeweils ein bleiloses Keramikmaterial aufweisen und sich in einer der vorgenannten Eigenschaften unterscheiden.

Weiterhin können die erste piezoelektrische Schicht ein erstes Keramikmaterial und die zweite piezoelektrische Schicht ein zweites Keramikmaterial aufweisen. Das erste und zweite Keramikmaterial können jeweils dieselben Bestandteile aufweisen und sich dabei in der Konzentration zumindest eines Bestandteils unterscheiden. Dies sei im Folgenden am Beispiel von PZT beschrieben, wobei die nachfolgende Beschreibung nicht auf dieses Keramikmaterial beschränkt ist und für jedes andere piezoelektrische Keramikmaterial ebenfalls gilt. Im Falle von PZT als erstes und zweite Keramikmaterial können sich die erste und zweite piezoelektrische Schicht beispielsweise im Titangehalt, also der jeweiligen Konzentration des Bestandteils Titan, voneinander unterschieden. Weiterhin können sich die erste und zweite piezoelektrische Schicht auch ausschließlich im Titangehalt unterscheiden, während andere Eigenschaften wie etwa die jeweilige Dotierung der ersten und zweiten piezoelektrischen Schicht gleich sind.

Die Erfinder haben insbesondere herausgefunden, dass ein Keramikmaterial für die erste und zweite piezoelektrische Schicht von Vorteil sein kann, das eine so genannte Morphotropenphasengrenze aufweist. Das kann insbesondere bedeuten, dass die erste und zweite piezoelektrische Schicht ein Keramikmaterial mit denselben Bestandteilen aufweisen und das Keramikmaterial in Abhängigkeit der Konzentration zumindest eines ersten Bestandteils eine Morphotropenphasengrenze aufweist, die zwischen einer ersten Struktur und einer zweiten Struktur des Keramikmaterials liegt. Die Konzentration des ersten Bestandteils des Keramikmaterials in der ersten und zweiten piezoelektrischen Schicht ist jeweils derart gewählt, dass die erste piezoelektrische Schicht das Keramikmaterial mit der ersten Struktur und die zweite piezoelektrische Schicht das Keramikmaterial mit der zweiten Struktur aufweist. Dabei unterscheiden sich das erste und zweite Keramikmaterial dann in ihrer jeweiligen Zusammensetzung, insbesondere in der jeweiligen Konzentration genau des vorab genannten ersten Bestandteils, dadurch, dass ein Übergang zwischen der ersten und zweiten Struktur in Abhängigkeit von der Konzentration des Bestandteils durch einen Phasenübergang an der Morphotropenphasengrenze gekennzeichnet ist. Dabei muss die Morphotropenphasengrenze keinen scharf definierten Phasenübergang kennzeichnen, sondern kann auch einen kontinuierlichen Verlauf zwischen zwei Kristallstrukturen darstellen. Durch die unterschiedliche erste und zweite Struktur können dabei die erste und zweite piezoelektrische Schicht unterschiedliche Koerzitivfeldstärken aufweisen. Beispielsweise weist PZT eine Morphotropenphasengrenze in einem Bereich von etwa 50 mol% Titan und etwa 50 mol% Zirkon auf, wobei diese Werte von der exakten Zusammensetzung des Keramikmaterials abhängen. So gibt es eine Zusammensetzung von PZT, die bei etwa 46 mol% des Bestandteils Titan eine Morphotropenphasengrenze aufweist. Mit zunehmendem Titangehalt, beginnend von weniger als 46 mol% Titan, steigt die Koerzitivfeldstärke beim Überschreiten der Morphotropenphasengrenze an, so dass für das piezoelektrische Bauelement beispielsweise die erste piezoelektrische Schicht mit einem Titangehalt von weniger als 46 mol% und die zweite piezoelektrische Schicht mit einem Titangehalt von mehr als 46 mol% gewählt werden kann.

Durch eine Auswahl eines hinsichtlich seiner Bestandteile gleichen Keramikmaterials für die erste und zweite piezoelektrische Schicht, das sich in der Konzentration zumindest eines Bestandteils für die erste und zweite piezoelektrische Schicht unterscheidet, ergibt sich der Vorteil, dass eine genaue Kontrolle der elastischen Spannungen an der Kontaktgrenze, also dem Interface, zwischen der ersten und zweiten piezoelektrischen Schicht ermöglicht wird. Weiterhin ist eine Anpassung der ersten und zweiten Koerzitivfeldstärke durch den Unterschied der Konzentration des zumindest einen Bestandteils möglich, also im oben beschriebenen Beispiel etwa durch die Änderung des Titangehalts. Weiterhin zusätzlich zugefügte Dotierstoffe können dabei in gleichen Dotierstoffkonzentrationen vorliegen. Dies kann besondere Vorteile bei der Prozessierung des piezoelektrischen Bauelements bieten, da mögliche chemische Inhomogenitäten zwischen der ersten und zweiten piezoelektrischen Schicht minimiert werden können und so im piezoelektrischen Bauelement minimal sein können und daher keinen Einfluss auf das Sinterverhalten der piezoelektrischen Schichten haben. Insbesondere bei unterschiedlichen Dotierstoffen und/oder Dotierstoffkonzentrationen kann das Sinterverhalten von Keramikmaterialien stark geändert sein, so dass dann eine spezielle Anpassung des Sinterschwunds zwischen derartig verschiedenen Materialien nötig ist.

Weiterhin können sich die erste und zweite piezoelektrische Schicht in ihrer Zusammensetzung dahingehend unterscheiden, dass die erste und zweite piezoelektrische Schicht Keramikmaterialen hergestellt aus Ausgangspulvern mit unterschiedlichen Partikelgrößen aufweisen. Typischerweise werden die keramischen Schichten eines piezoelektrischen Bauelements aus so genannten Grünfolien hergestellt, die neben weitern Bestandteilen wie etwa Sinterhilfsmitteln ungesintertes Keramikpulver aufweisen, wobei die Grünfolien anschließend mit den Elektrodenschichten zusammengefügt und gesintert werden. Die Erfinder haben herausgefunden, dass sich Keramikmaterialien, die etwa in ihrer chemischen Zusammensetzung gleich sind und sich in den Ausgangsgrößen der Pulver vor dem Sintervorgang unterscheiden, geeignet sind, um die erste und zweite piezoelektrische Schicht herzustellen. Keramikmaterialen mit gröberem Ausgangspulver weisen nach Abschluss des Sintervorgangs üblicherweise gröbere Körner auf, was zu einer Reduktion der Koerzitivfeldstärke führen kann.

Die Partikelgröße wird dabei bevorzugt als dem Fachmann bekannter Medianwert d50 der Verteilung der Partikelgrößen im jeweiligen Keramikmaterial angegeben. Die Partikelgröße d50 der Ausgangspulver der ersten und zweiten piezoelektrischen Schicht vor dem Sintervorgang kann bevorzugt größer oder gleich 0,3 µm und kleiner oder gleich 2,0 µm sein und besonders bevorzugt größer oder gleich 0,4 µm und kleiner oder gleich 1,2 µm.

Falls ein Unterschied der Koerzitivfeldstärken der ersten und zweiten Schicht durch den Unterschied der Korngrößen, also der Partikelgrößen, der Ausgangspulver erreicht werden soll, ist der Unterschied des d50-Werts der ersten piezoelektrischen Schicht zum d50-Wert der zweiten piezoelektrischen Schicht bevorzugt größer oder gleich 0,1 µm und kleiner oder gleich 1,5 µm und besonders bevorzugt größer oder gleich 0,3 µm und kleiner oder gleich 1,0 µm. Die Erfinder haben herausgefunden, dass derartige Partikelgrößen und Partikelgrößenunterschiede besonders vorteilhaft für die Prozessierbarkeit des piezoelektrischen Bauelements bei gleichzeitiger Wahl der ersten und zweiten Koerzitivfeldstärke sind.

Weiterhin können sich die erste und zweite piezoelektrische Schicht in den ihnen zugefügten Dotierstoffen unterscheiden. Insbesondere können die erste und zweite piezoelektrische Schicht dabei dasselbe Keramikmaterial mit denselben Bestandteilen und denselben Konzentrationen aufweisen, wobei dem Keramikmaterial der ersten piezoelektrischen Schicht ein anderer Dotierstoff zugesetzt ist wie dem Keramikmaterial der zweiten piezoelektrischen Schicht. Dabei kann die erste piezoelektrische Schicht beispielsweise mit Neodym (Nd) dotiert sein, während die zweite piezoelektrische Schicht mit einer Mischung aus Zink (Zn) und Niobium (Nb) dotiert ist. Eine derartige Dotierstoffkombination kann insbesondere im Falle von PZT, aber auch im Falle anderer Keramikmaterialen, als Keramikmaterial für beide Schichten vorteilhaft sein. Weiterhin können die erste und zweite piezoelektrische Schicht unterschiedliche Dotierstoffkonzentrationen aufweisen. Dabei können beide Schichten auch denselben Dotierstoff aufweisen. Für PZT als Keramikmaterial und eine Mischung aus Zn und Nb als Dotierstoffe können beispielsweise die erste piezoelektrische Schicht eine Dotierstoffkonzentration von 2 mol% und die zweite piezoelektrische Schicht eine Dotierstoffkonzentration von 5 mol% aufweisen. Die jeweiligen Dotierstoffe und Dotierstoffkonzentrationen hängen dabei von den jeweiligen Keramikmaterialen und den gewünschten Koerzitivfeldstärken ab.

Weiterhin können die erste piezoelektrische Schicht eine erste Dicke und die zweite piezoelektrische Schicht eine zweite Dicke aufweisen, wobei die erste und zweite Dicke voneinander verschieden sind. Durch die Einstellung der ersten und zweiten Dicke kann eine Anpassung der ersten und zweiten Koerzitivfeldstärke möglich sein. Insbesondere kann in dieser Ausführungsform die erste piezoelektrische Schicht direkt benachbart zu einer ersten Elektrodenschicht und zu einer zweiten Elektrodenschicht angeordnet sein, so dass die erste piezoelektrische Schicht zwischen einem Paar gebildet aus der ersten und zweiten Elektrodenschicht angeordnet ist. Die zweite piezoelektrische Schicht kann zwischen einem weiteren Paar gebildet aus einer ersten und einer zweiten Elektrodenschicht angeordnet sein, wobei entweder die erste oder die zweite Elektrodenschicht dieselbe für beide Paare ist. Die elektrische Feldstärke E in der ersten und der zweiten piezoelektrischen Schicht ist dabei von der angelegten Spannung U und der ersten beziehungsweise der zweiten Schichtdicke abhängig gemäß der Gleichung E=U/t, wobei t die erste oder die zweite Dicke angibt. Dabei können die erste und zweite piezoelektrische Schicht dasselbe Keramikmaterial mit Übereinstimmung in Zusammensetzung, Dotierstoffen, Dotierstoffkonzentrationen und Partikelgrößen aufweisen, so dass das piezoelektrische Bauelement gänzlich aus demselben Keramikmaterial herstellbar ist und die erste und zweite Koerzitivfeldstärke durch die Abstände von ersten und zweiten Elektrodenschichten einstellbar sind.

Der Unterschied der ersten Dicke zur zweiten Dicke, bezogen auf eine normale Schichtdicke, beziehungsweise das Verhältnis der ersten und zweiten Dicke zueinander kann bevorzugt größer oder gleich 1,1 und kleiner oder gleich 3,0 und besonders bevorzugt größer oder gleich 1,3 und kleiner oder gleich 2,5 sein.

Gemäß zumindest einer Ausführungsform weist der Stapel des piezoelektrischen Bauelements eine Abfolge von direkt übereinander angeordneten Schichen auf, wobei die Abfolge in dieser Reihenfolge gebildet ist aus einer ersten Elektrodenschicht, der ersten piezoelektrischen Schicht, einer zweiten Elektrodenschicht, der zweiten piezoelektrischen Schicht und einer weiteren ersten Elektrodenschicht. Zwischen jeweils einer benachbarten ersten und zweiten Elektrodenschicht ist somit die erste piezoelektrischen Schicht angeordnet, während zwischen derselben zweiten Elektrodenschicht und einer weiteren, zur zweiten Elektrodenschicht benachbarten ersten Elektrodenschicht die zweite piezoelektrische Schicht angeordnet ist.

Gemäß zumindest einer weiteren Ausführungsform weist der Stapel des piezoelektrischen Bauelements eine Abfolge von direkt übereinander angeordneten Schichten auf, wobei die Abfolge in dieser Reihenfolge gebildet ist aus einer ersten Elektrodenschicht, der ersten piezoelektrischen Schicht, der zweiten piezoelektrischen Schicht und einer zur ersten Elektrodenschicht benachbarten zweiten Elektrodenschicht. Die erste und zweite piezoelektrische Schicht befinden sich hierbei also zwischen demselben Paar gebildet aus einer ersten Elektrodenschicht und einer dazu benachbarten zweiten Elektrodenschicht.

Weiterhin können die beiden vorgenannten Abfolgen beide in einem piezoelektrischen Bauelement angeordnet sein.

Weiterhin kann der Stapel des piezoelektrischen Bauelements weitere erste piezoelektrische Schichten und zumindest die eine zweite piezoelektrische Schicht aufweisen. Das kann insbesondere bedeuten, dass das piezoelektrische Bauelement einen Stapel mit wenigstens genau einer zweiten piezoelektrischen Schicht und einer Mehrzahl aus ersten piezoelektrischen Schichten aufweisen kann. Darüber hinaus kann das piezoelektrische Bauelement auch eine Mehrzahl an zweiten piezoelektrischen Schichten aufweisen. Maximal kann der Stapel des piezoelektrischen Bauelements gleich viele erste und zweite piezoelektrische Schichten aufweisen, so dass die Hälfte aller piezoelektrischen Schichten im Stapel erste beziehungsweise zweite piezoelektrische Schichten sind.

Weiterhin können die Elektrodenschichten eines der folgenden Materialien aufweisen: Kupfer, Silber, Platin, eine Legierung oder Mischung aus Kupfer und Palladium, eine Legierung oder Mischung aus Silber und Palladium, eine Mischung oder Legierung aus Platin und Silber.

Weitere Vorteile und vorteilhafte Ausführungsformen und Weiterbildungen der Erfindung ergeben sich aus den im Folgenden in Verbindung mit den Figuren 1 bis 10 beschriebenen Ausführungsformen.

Es zeigen:
- Figur 1: eine schematische Darstellung eines bekannten piezoelektrischen Aktors,
- Figuren 2A und 2B: schematische Darstellungen bekannter piezoelektrischer Aktoren,
- Figuren 3A bis 3C: schematische Darstellungen von piezoelektrischen Materialien gemäß einer Ausführungsform,
- Figur 4: eine schematische Darstellung eines piezoelektrischen Bauelements gemäß einer Ausführungsform,
- Figur 5: eine schematische Darstellung eines piezoelektrischen Bauelements gemäß einer weiteren Ausführungsform,
- Figur 6: eine schematische Darstellung eines piezoelektrischen Bauelements gemäß einer weiteren Ausführungsform,
- Figur 7: eine schematische Darstellung eines piezoelektrischen Bauelements gemäß einer weiteren Ausführungsform und
- Figuren 8 bis 10: Graphen von verschiedenen Parametern piezoelektrischer Materialien gemäß weiterer Ausführungsformen.

In den Ausführungsbeispielen und Figuren können gleiche oder gleich wirkende Bestandteile jeweils mit den gleichen Bezugszeichen versehen sein. Die dargestellten Elemente und deren Größenverhältnisse untereinander sind grundsätzlich nicht als maßstabsgerecht anzusehen, vielmehr können einzelne Elemente, wie zum Beispiel Schichten, Bauteile, Bauelemente und Bereiche, zur besseren Darstellbarkeit und/oder zum besseren Verständnis übertrieben dick oder groß dimensioniert dargestellt sein.

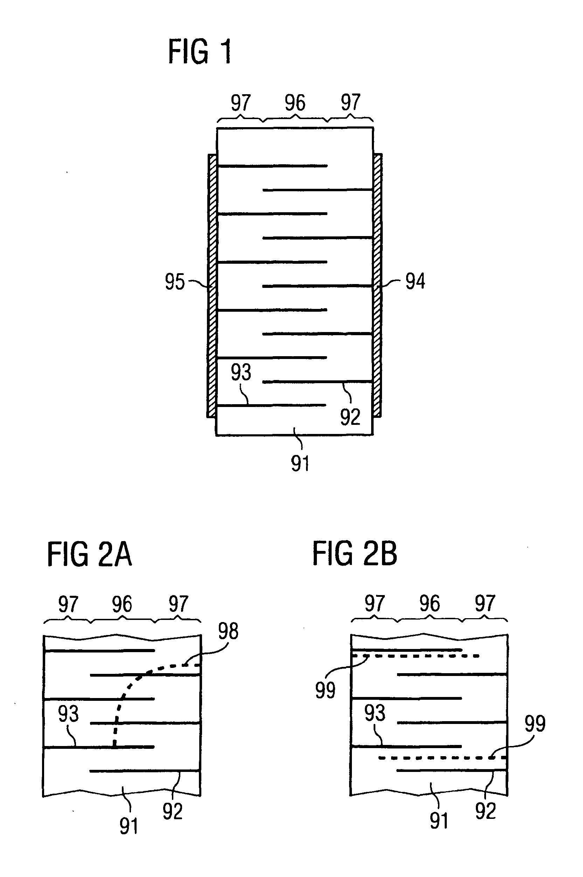

In Figur 1 ist ein bekannter vielschichtiger piezoelektrischer Aktor dargestellt, der einen Stapel 91 mit mehreren Schichten eines piezoelektrischen Materials mit Innenelektroden 92, 93 zwischen den piezoelektrischen Schichten aufweist. Dabei ist im ganzen Aktor das gleiche piezoelektrische Material verwendet. Die Innenelektroden 92, 93 sind jeweils in einer Art Kammstruktur in Form von ineinander geschobenen Kämmen ausgebildet. Über Kontaktflächen in Form von Metallisierungen 94, 95 an der Außenseite des Stapel 91 kann zwischen den Innenelektroden 92, 93 eine elektrische Spannung angelegt werden. Im aktiven Bereich 96 des Stapel 91, in dem die Innenelektroden 92, 93 wechselweise übereinander angeordnet sind, kann ein piezoelektrischer Hub durch eine Dehnung des piezoelektrischen Materials des Aktors bewirkt werden. In den inaktiven Bereichen 97 des Stapels 91 wird durch das Anlegen einer elektrischen Spannung an die Innenelektroden 92, 93 lediglich ein sehr geringes elektrisches Feld aufgebaut, so dass in diesen Bereichen das piezoelektrische Material kaum zum Hub des Aktors beiträgt. Dadurch entstehen in den inaktiven Bereichen 97 Zugspannungen, die Entlastungs- und/oder Polungsrisse hervorrufen können, wie in den Figuren 2A und 2B schematisch gezeigt ist. Dabei können, wie in Figur 2B gezeigt, Polungsrisse 99 entstehen, die weitgehend parallel zu den Innenelektroden 92, 93 verlaufen. Daneben entstehen in bekannten piezoelektrischen Aktoren aber auch Polungsrisse 98, wie in Figur 2A gezeigt, die beim Übergang in den aktiven Bereich 96 abknicken und dann, wie angedeutet, Innenelektroden überbrücken können, so dass Kurzschlüsse entstehen. Ein Polungsriss 98 wie in Figur 2A gezeigt führt zum Versagen des bekannten piezoelektrischen Aktors aus Figur 1.

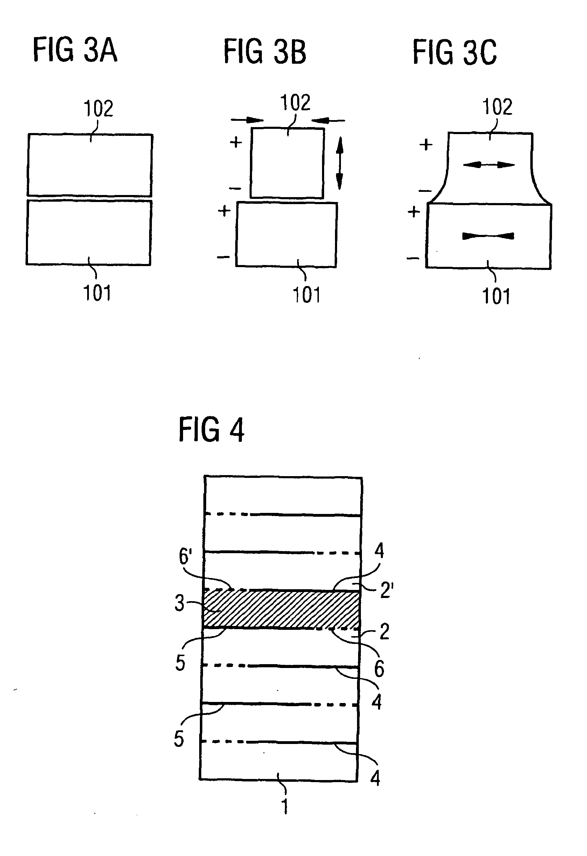

In den Figuren 3A bis 3C ist ein Ausführungsbeispiel mit schematischen Darstellungen von piezoelektrischen Materialien 101, 102 gezeigt, die die Grundidee des hier beschriebenen piezoelektrischen Bauelements verdeutlichen sollen. Dabei weisen das erste piezoelektrische Material 101 eine erste Koerzitivfeldstärke und das zweite piezoelektrische Material 102 eine zweite Koerzitivfeldstärke auf (Figur 3A), wobei im gezeigten Ausführungsbeispiel die zweite Koerzitivfeldstärke kleiner als die erste Koerzitivfeldstärke ist. Figur 3B zeigt schematisch die Verformung des ersten und zweiten piezoelektrischen Materials 101, 102 nach dem Anlegen eines elektrischen Feldes (angedeutet durch die Plus- und Minuszeichen, Elektrodenschichten sind nicht gezeigt), wenn es keinen mechanischen Kontakt zwischen dem ersten und zweiten piezoelektrischen Material 101, 102 gibt. Die durch das elektrische Feld hervorgerufene Verformung ist dabei beispielhaft für das piezoelektrische Material 102 durch die Pfeile verdeutlicht. Das zweite piezoelektrische Material 102 mit der kleineren Koerzitivfeldstärke dehnt sich dabei stärker als das erste piezoelektrische Material 101. Werden die piezoelektrischen Materialien 101, 102 miteinander in Kontakt gebracht und anschließend zusammen gesintert, entsteht beim Anlegen einer elektrischen Spannung eine Verformung des ersten und zweiten piezoelektrischen Materials 101, 102, wie sie in Figur 3C gezeigt ist. Da das erste und zweite piezoelektrische Material 101, 102 fest miteinander verbunden sind, entstehen an der Grenzfläche zwischen diesen elastische Spannungen, die sich aus den unterschiedlichen Dehnungen und der daraus resultierenden Zugspannung im Material 102 und der Druckspannung im Material 101 (jeweils angedeutet durch die Doppelpfeile) ergeben. An der Kontaktgrenze zwischen dem ersten und dem zweiten piezoelektrischen Material 101, 102 bildet sich somit ein Gradient der elastischen Spannungen, der zur Bildung von Rissen in diesem Bereich führen soll.

In Figur 4 ist ein Ausführungsbeispiel für ein piezoelektrisches Bauelement gezeigt, das als Piezoaktor in Vielschichtbauweise ausgeführt ist und das einen Stapel 1 aus übereinander angeordneten piezoelektrischen Schichten und dazwischen angeordneten ersten und zweiten Elektrodenschichten aufweist, wobei der Übersichtlichkeit halber lediglich die piezoelektrischen Schichten 2, 2' und 3 sowie einige erste Elektrodenschichten 4 und zweite Elektrodenschichten 5 mit Bezugszeichen versehen sind. Die gestrichelten Linien sind zu Verdeutlichung der piezoelektrischen Schichten eingezeichnet. Der Stapel 1 weist dabei zumindest eine erste piezoelektrische Schicht 2 mit einer ersten Koerzitivfeldstärke und direkt zu dieser benachbart zumindest eine zweite piezoelektrische Schicht 3 mit einer zweiten Koerzitivfeldstärke auf, wobei die erste und zweite Koerzitivfeldstärke verschieden voneinander sind. Nicht gezeigt sind Metallisierungen an Außenseiten des Stapels 1, um die ersten und zweiten Elektrodenschichten 4, 5 zu kontaktieren und an eine elektrische Spannung anzuschließen. Die Elektrodenschichten 4, 5 sind aus Kupfer.

Die erste und zweite piezoelektrische Schicht 2, 3 sind jeweils zwischen zwei benachbarten Elektrodenschichten 4, 5 angeordnet, so dass der Stapel 1 eine Abfolge von Schichten aufweist, die gebildet wird durch eine erste Elektrodenschicht 4, die erste piezoelektrische Schicht 2, eine zweite Elektrodenschicht 5, die zweite piezoelektrische Schicht 3 und eine weitere erste Elektrodenschicht 4. Nach dem vorab in den Figuren 3A bis 3C beschriebenen Prinzip unterscheiden sich die erste und zweite Koerzitivfeldstärke derart, dass an der Kontaktgrenze 6 zwischen der ersten und zweiten piezoelektrischen Schicht bei thermischen Behandlungen, beim Metallisieren, beim Löten, beim Polungsprozess und/oder im Betrieb des piezoelektrischen Bauelements lokale elastische Spannungen entstehen, die im Bereich der Kontaktgrenze zur Bildung von Entlastungs- und/oder Polungsrissen führen, die im Wesentlichen parallel zu den Elektrodenschichten 4, 5 verlaufen. Weiterhin weist der Stapel 1 eine weitere erste piezoelektrische Schicht 2' auf, die ebenfalls direkt benachbart zur zweiten piezoelektrischen Schicht 3 angeordnet ist und die mit letzterer eine weitere Kontaktgrenze 6' aufweist, an der sich gezielt Entlastungs- und/oder Polungsrisse bilden können.

Die ersten piezoelektrischen Schichten 2, 2' und die zweite piezoelektrische Schicht 3 weisen im gezeigten Ausführungsbeispiel jeweils ein Keramikmaterial basierend auf PZT auf, wobei die zweite piezoelektrische Schicht 3 eine Zusammensetzung mit einer anderen Konzentration des Bestandteils Titan als die ersten piezoelektrischen Schicht 2, 2' aufweist. Die Schichtdicken der piezoelektrischen Schichten 2, 2', 3 sind im gezeigten Ausführungsbeispiel gleich.

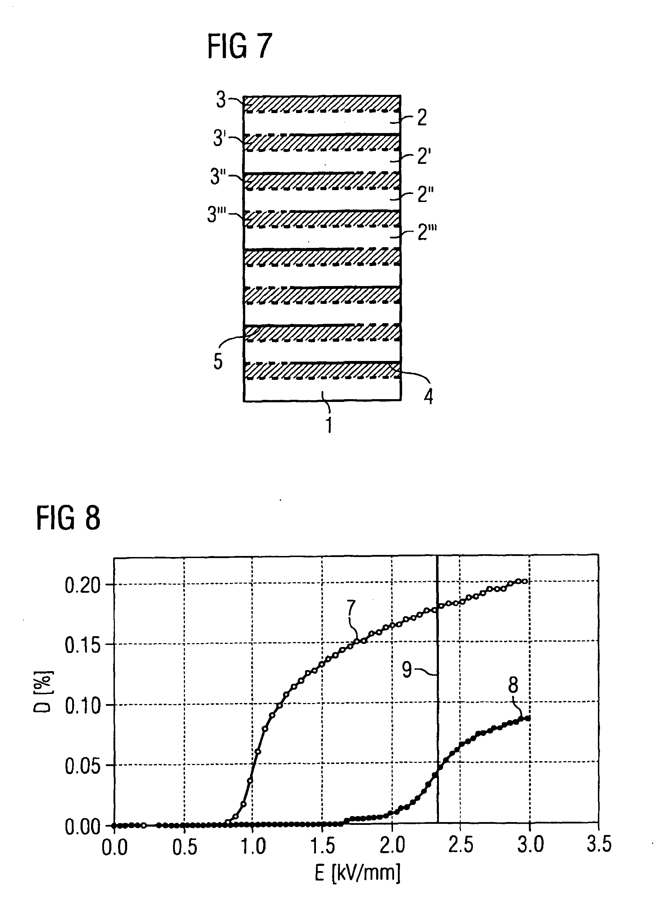

Ausführungsbeispiele für die elastische Dehnung und Koerzitivfeldstärken solcher piezoelektrischer Materialien sind in Zusammenhang mit den Figuren 8 bis 10 beschrieben.

Weiterhin können die ersten und zweiten piezoelektrischen Schichten in diesem und den weiteren Ausführungsbeispielen zusätzlich oder alternativ auch eines oder mehrere Merkmale wie im allgemeinen Teil beschrieben aufweisen, etwa unterschiedliche Dotierstoffe, Dotierstoffkonzentrationen, Partikelgrößen oder Dicken.

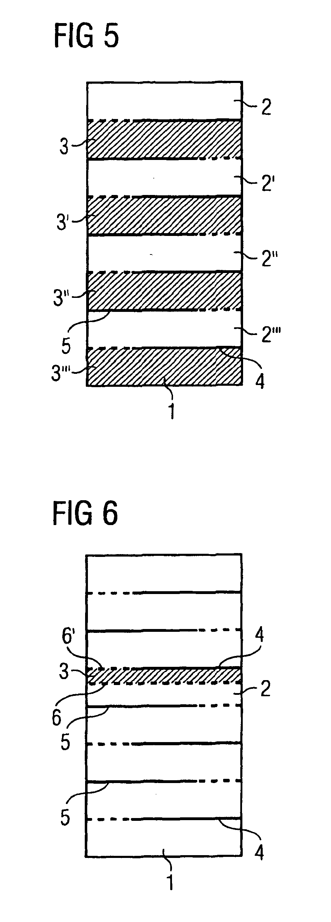

In Figur 5 ist ein weiteres Ausführungsbeispiel für ein piezoelektrisches Bauelement gezeigt. Im Vergleich zum vorhergehenden Ausführungsbeispiel weist der Stapel 1 des piezoelektrischen Bauelements gemäß Figur 5 neben einer Mehrzahl an ersten piezoelektrischen Schichten 2, 2' ,2" , 2"' auch eine Mehrzahl von zweiten piezoelektrischen Schichten 3, 3' , 3" , 3"' auf, wobei die ersten und zweiten piezoelektrischen Schichten abwechseln übereinander angeordnet sind, so dass sich eine Mehrzahl an Kontaktgrenzen ergibt, an denen sich gezielt Entlastungs- und/oder Polungsrisse bilden können. Die Anzahl der zweiten piezoelektrischen Schichten 3, 3', 3" , 3"' im Verhältnis zur Anzahl der ersten piezoelektrischen Schichten 2, 2', 2", 2"' kann dabei nach den jeweiligen Anforderungen und den ersten und zweiten Koerzitivfeldstärken gewählt werden. Im gezeigten Ausführungsbeispiel weist der Stapel 1 rein beispielhaft gleich viele erste und zweite piezoelektrische Schichten auf, so dass 50% aller piezoelektrischen Schichten im Stapel 1 als zweite piezoelektrische Schichten ausgebildet sind.

In den Figuren 6 und 7 sind weitere Ausführungsbeispiele für piezoelektrische Bauelemente gezeigt, die sich von den Ausführungsbeispielen der Figuren 4 und 5 dadurch unterscheiden, dass eine erste und eine zweite piezoelektrische Schicht 2, 3 direkt benachbart zueinander und gemeinsam zwischen einer ersten Elektrodenschicht und einer zu dieser benachbarten zweiten Elektrodenschicht 5 angeordnet sind. Gemäß dem Ausführungsbeispiel in Figur 7 umfassen dabei alle piezoelektrischen Schichten zwischen zwei jeweils benachbarten Elektrodenschichten 4, 5 eine erste und eine zweite piezoelektrische Schicht 2, 2', 2" , 2"', 3, 3', 3", 3"'. Alternativ zu den Ausführungsbeispielen der Figuren 6 und 7 können auch mehr als eine erste und eine zweite piezoelektrische Schicht zwischen zwei benachbarten Elektrodenschichten 4, 5 angeordnet sein. Im Übrigen gilt das in Zusammenhang mit den Ausführungsbeispielen der Figuren 4 und 5 gesagte auch für die Ausführungsbeispiele der Figuren 6 und 7.

In Figur 8 ist ein Graph mit Kurven 7, 8 für die elastische Dehnung D in % als Funktion der angelegten elektrischen Feldstärke E in kV/mm in zwei verschiedenen, beispielhaft gezeigten piezoelektrischen Materialien gemäß einem Ausführungsbeispiel gezeigt, aus denen erste und zweite piezoelektrische Schichten der vorangegangenen Ausführungsbeispiele hergestellt werden können. Das piezoelektrische Material, dessen Dehnung senkrecht zum elektrischen Feld in Kurve 7 dargestellt ist, weist eine Koerzitivfeldstärke von 1,0 kV/mm auf, während das piezoelektrische Material, dessen Dehnung senkrecht zum elektrischen Feld in Kurve 8 gezeigt ist, eine Koerzitivfeldstärke von 2,3 kV/mm aufweist. Wenn das angelegte elektrische Feld die jeweilige Koerzitivfeldstärke übersteigt, entsteht im piezoelektrischen Material eine Dehnung sowohl in Richtung als auch senkrecht zum angelegten Feld (siehe auch Figur 3B). In dem Material zur Kurve 7, wo die Koerzitivfeldstärke kleiner ist als die mit dem Bezugszeichen 9 beispielhaft gekennzeichnete Feldstärke von 2,3 kV/mm, wird eine hohe Dehnung bis zu 0,17% in der Richtung senkrecht zum angelegten elektrischen Feld erreicht. Das Material zur Kurve 8, dessen Koerzitivfeldstärke größer oder - wie hier gezeigt - vergleichbar mit dem Wert des angelegten elektrischen Felds ist, weist hingegen eine deutlich geringere Dehnung von 0,03% auf.

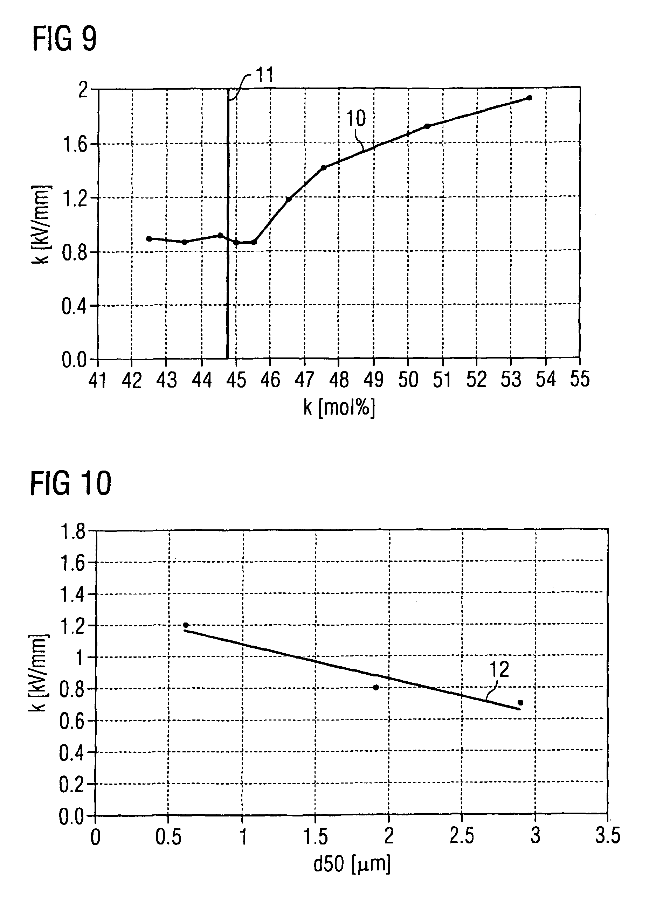

In Figur 9 ist ein Graph für die mit Kurve 10 gezeigte Abhängigkeit der Koerzitivfeldstärke K in kV/mm von der Konzentration k in mol% des Titangehalts in einem piezoelektrischen Material auf Blei-Zirkon-Titanat-Basis gemäß einem Ausführungsbeispiel dargestellt. Mit dem Bezugszeichen 11 ist die Morphotropenphasengrenze des piezoelektrischen Materials angedeutet, die im Bereich zwischen 44 und 46 mol% der Titankonzentration liegt. Mit ansteigendem Titangehalt ist nach dem Überschreiten der Morphotropenphasengrenze ein Anstieg der Koerzitivfeldstärke K zu erkennen. Wie im allgemeinen Teil beschrieben, können für die erste piezoelektrische Schicht und für die zweite piezoelektrische Schicht Keramikmaterialen mit der gleichen Zusammensetzung gewählt werden, die Koerzitivfeldstärken auf verschiedenen Seiten der Morphotropenphasengrenze 11 aufweisen. So kann beispielsweise für die erste piezoelektrische Schicht ein Material mit einem Titangehalt von weniger als etwa 46% und für die zweite piezoelektrische Schicht ein Material mit einem Titangehalt von mehr als etwa 46% ausgewählt werden, so dass die erste Koerzitivfeldstärke kleiner ist als die zweite Koerzitivfeldstärke.

In Figur 10 ist ein Graph für die mit Kurve 12 gezeigte Abhängigkeit der Koerzitivfeldstärke K in kV/mm von der oben beschriebenen Partikelgröße d50 im Keramikmaterial gemäß einem weiteren Ausführungsbeispiel dargestellt. Das in Zusammenhang mit Figur 10 untersuchte Keramikmaterial basiert auf einer PZT-Keramik, wobei zu erkennen ist, dass mit steigender Partikelgröße d50 die Koerzitivfeldstärke des Keramikmaterials sinkt.

Die vorab explizit erwähnten Keramikmaterialen sind rein beispielhaft genannt und sind nicht als Beschränkung der vorliegenden Erfindung zu verstehen. Vielmehr können die vorab beschriebenen Ausführungsformen und Ausführungsbeispiele auch andere piezoelektrische Keramikmaterialen als die genannten Keramikmaterialen aufweisen.

### Bezugszeichenliste

- 1: Stapel
- 2, 2', 2'' , 2''': erste piezoelektrische Schicht
- 3, 3' , 3'', 3''': zweite piezoelektrische Schicht
- 4: erste Elektrodenschicht
- 5: zweite Elektrodenschicht
- 6, 6': Kontaktgrenze
- 7: Dehnung
- 8: Dehnung
- 9: elektrische Feldstärke
- 10: Koerzitivfeldstärke
- 11: Morphotropenphasengrenze
- 12: Koerzitivfeldstärke
- 91: Stapel
- 92: Innenelektrode
- 93: Innenelektrode
- 94: Metallisierung
- 95: Metallisierung
- 96: aktiver Bereich
- 97: inaktiver Bereich
- 98: Polungsriss
- 99: Polungsriss
- 101: piezoelektrisches Material
- 102: piezoelektrisches Material

## Patentansprüche

1. Piezoelektrisches Bauelement
mit einem Stapel (1) aus übereinander angeordneten piezoelektrischen Schichten (2, 2', 2", 2"', 3, 3', 3'', 3"') und dazwischen angeordneten ersten und zweiten Elektrodenschichten (4, 5),
bei dem der Stapel (1) zumindest eine erste piezoelektrische Schicht (2) mit einer ersten elektrischen Koerzitivfeldstärke und direkt dazu benachbart mindestens eine zweite piezoelektrische Schicht (3) mit einer zweiten elektrischen Koerzitivfeldstärke verschieden von der ersten Koerzitivfeldstärke aufweist, bei dem die erste piezoelektrische Schicht (2) und die zweite piezoelektrische Schicht (3) unterschiedliche Keramikmaterialien, unterschiedliche Dotierstoffe, unterschiedliche Dotierstoffkonzentrationen, unterschiedliche Partikelgrößen von Ausgangsmaterialien, unterschiedliche Schichtdicken oder eine Kombination daraus aufweisen,
bei dem die erste und zweite piezoelektrische Schicht (2, 3) ein Keramikmaterial gebildet aus mehreren Bestandteilen mit jeweiligen Konzentrationen aufweisen,
bei dem sich die die erste und zweite piezoelektrische Schicht (2, 3) in der Konzentration zumindest eines Bestandteils unterscheiden,
bei dem die erste und zweite piezoelektrische Schicht (2, 3) ein Keramikmaterial mit denselben Bestandteilen aufweisen,
bei dem das Keramikmaterial in Abhängigkeit der Konzentration zumindest eines ersten Bestandteils eine Morphotropenphasengrenze aufweist, die zwischen einer ersten Struktur und einer zweiten Struktur des Keramikmaterials liegt und
bei dem die Konzentration des ersten Bestandteils des Keramikmaterials in der ersten und zweiten piezoelektrischen Schicht (2, 3) jeweils derart gewählt sind, dass die erste piezoelektrische Schicht (2) das Keramikmaterial mit der ersten Struktur und die zweite piezoelektrische Schicht (3) das Keramikmaterial mit der zweiten Struktur aufweist.

2. Piezoelektrisches Bauelement nach dem vorherigen Anspruch,
bei dem die erste und zweite piezoelektrische Schicht (2, 3) jeweils derart gewählt sind, dass eine Kontaktgrenze (6) zwischen den beiden Schichten einen Bereich zur Bildung von Entlastungs- und/oder Polungsrissen bildet, die im Wesentlichen parallel zu den Elektrodenschichten (4, 5) verlaufen.

3. Piezoelektrisches Bauelement nach dem vorherigen Anspruch,
bei dem sich die erste und zweite piezoelektrische Schicht (2, 3) in genau einer Eigenschaft ausgewählt aus unterschiedlichen Keramikmaterialien, unterschiedlichen Dotierstoffen, unterschiedlichen Dotierstoffkonzentrationen, unterschiedlichen Partikelgrößen von Ausgangsmaterialien und unterschiedlichen Schichtdicken unterscheiden.

4. Piezoelektrisches Bauelement nach einem der vorherigen Ansprüche,
bei dem die erste und zweite piezoelektrische Schicht (2, 3) Keramikmaterialen hergestellt aus Ausgangspulvern mit unterschiedlichen Partikelgrößen aufweisen.

5. Piezoelektrisches Bauelement nach dem vorherigen Anspruch,
bei dem die Partikelgröße d50 der Ausgangspulver größer oder gleich 0,3 µm und kleiner oder gleich 2,0 µm beträgt und
bei dem der Unterschied in den Partikelgrößen d50 der Ausgangspulver größer oder gleich 0,1 µm und kleiner oder gleich 1,5 µm beträgt.

6. Piezoelektrisches Bauelement nach einem der vorherigen Ansprüche,
bei dem die erste piezoelektrische Schicht (2) eine erste Dicke aufweist und die zweite piezoelektrische Schicht eine zweite Dicke aufweist und
bei dem die erste und zweite Dicke verschieden voneinander sind.

7. Piezoelektrisches Bauelement nach dem vorherigen Anspruch,
bei dem das Verhältnis der ersten und zweiten Dicke größer oder gleich 1,1 und kleiner oder gleich 3,0 beträgt.

8. Piezoelektrisches Bauelement nach einem der vorherigen Ansprüche,
bei dem der Stapel (1) eine Abfolge von direkt übereinander angeordneten Schichten aufweist und
bei dem die Abfolge gebildet ist aus einer ersten Elektrodenschicht (4), der ersten piezoelektrischen Schicht (2), einer zweiten Elektrodenschicht (5), der zweiten piezoelektrischen Schicht (3) und einer weiteren ersten Elektrodenschicht (4).

9. Piezoelektrisches Bauelement nach einem der vorherigen Ansprüche,
bei dem der Stapel (1) eine Abfolge von direkt übereinander angeordneten Schichten aufweist und
bei dem die Abfolge gebildet ist aus einer ersten Elektrodenschicht (4), der ersten piezoelektrischen Schicht (2), der zweiten piezoelektrischen Schicht (3) und einer zur ersten Elektrodenschicht benachbarten zweiten Elektrodenschicht (5).

10. Piezoelektrisches Bauelement nach einem der Ansprüche 8 oder 9,
bei dem der Stapel (1) weitere erste piezoelektrische Schichten (2', 2'', 2"') und die zumindest eine zweite piezoelektrische Schicht (3) aufweist.

11. Piezoelektrisches Bauelement nach einem der Ansprüche 8 bis 10,
bei dem der Stapel gleich viele erste und zweite piezoelektrische Schichten (2, 2', 2" , 2"' , 3, 3', 3", 3"') aufweist.

12. Piezoelektrisches Bauelement
mit einem Stapel (1) aus übereinander angeordneten piezoelektrischen Schichten (2, 2', 2", 2''', 3, 3', 3", 3"') und dazwischen angeordneten ersten und zweiten Elektrodenschichten (4, 5),
bei dem der Stapel (1) zumindest eine erste piezoelektrische Schicht (2) mit einer ersten elektrischen Koerzitivfeldstärke und direkt dazu benachbart mindestens eine zweite piezoelektrische Schicht (3) mit einer zweiten elektrischen Koerzitivfeldstärke verschieden von der ersten Koerzitivfeldstärke aufweist, bei dem die erste piezoelektrische Schicht (2) und die zweite piezoelektrische Schicht (3) unterschiedliche Keramikmaterialien, unterschiedliche Dotierstoffe, unterschiedliche Dotierstoffkonzentrationen, unterschiedliche Partikelgrößen von Ausgangsmaterialien, unterschiedliche Schichtdicken oder eine Kombination daraus aufweisen, **dadurch gekennzeichnet, dass**
die erste piezoelektrische Schicht (2) eine erste Dicke aufweist und die zweite piezoelektrische Schicht eine zweite Dicke aufweist,
die erste und zweite Dicke verschieden voneinander sind und
das Verhältnis der ersten und zweiten Dicke größer oder gleich 1,1 und kleiner oder gleich 3,0 beträgt.

## Claims

1. Piezoelectric component
comprising a stack (1) of piezoelectric layers (2, 2', 2" , 2"', 3, 3', 3", 3"') arranged one above another and first and second electrode layers (4, 5) arranged therebetween,
wherein the stack (1) has at least one first piezoelectric layer (2) having a first electric coercive field strength and, directly adjacent thereto, at least one second piezoelectric layer (3) having a second electric coercive field strength different than the first coercive field strength,
wherein the first piezoelectric layer (2) and the second piezoelectric layer (3) comprise different ceramic materials, different dopants, different dopant concentrations, different particle sizes of starting materials, different layer thicknesses or a combination thereof,
wherein the first and second piezoelectric layers (2, 3) comprise a ceramic material formed from a plurality of constituents having respective concentrations,
wherein the first and second piezoelectric layers (2, 3) differ in the concentration of at least one constituent,
wherein the first and second piezoelectric layers (2, 3) comprise a ceramic material having the same constituents,
wherein the ceramic material has, depending on the concentration of at least one first constituent, a morphotropic phase boundary lying between a first structure and a second structure of the ceramic material, and
wherein the concentration of the first constituent of the ceramic material in the first and second piezoelectric layers (2, 3), is in each case chosen in such a way that the first piezoelectric layer (2) comprises the ceramic material having the first structure and the second piezoelectric layer (3) comprises the ceramic material having the second structure.

2. Piezoelectric component according to the preceding claim,
wherein the first and second piezoelectric layers (2, 3) are in each case chosen in such a way that a contact boundary (6) between the two layers forms a region for forming load-relieving and/or polarization cracks which run substantially parallel to the electrode layers (4, 5).

3. Piezoelectric component according to the preceding claim,
wherein the first and second piezoelectric layers (2, 3) differ in exactly one property selected from different ceramic materials, different dopants, different dopant concentrations, different particle sizes of starting materials and different layer thicknesses.

4. Piezoelectric component according to any of the preceding claims,
wherein the first and second piezoelectric layers (2, 3) comprise ceramic materials produced from starting powders having different particle sizes.

5. Piezoelectric component according to the preceding claim,
wherein the particle size d50 of the starting powders is greater than or equal to 0.3 µm and less than or equal to 2.0 µm, and
wherein the difference in the particle sizes d50 of the starting powders is greater than or equal to 0.1 µm and less than or equal to 1.5 µm.

6. Piezoelectric component according to any of the preceding claims,
wherein the first piezoelectric layer (2) has a first thickness and the second piezoelectric layer has a second thickness, and
wherein the first and second thicknesses are different from one another.

7. Piezoelectric component according to the preceding claim,
wherein the ratio of the first and second thicknesses is greater than or equal to 1.1 and less than or equal to 3.0.

8. Piezoelectric component according to any of the preceding claims,
wherein the stack (1) has a sequence of layers arranged directly one above another, and
wherein the sequence is formed from a first electrode layer (4), the first piezoelectric layer (2), a second electrode layer (5), the second piezoelectric layer (3) and a further first electrode layer (4).

9. Piezoelectric component according to any of the preceding claims,
wherein the stack (1) has a sequence of layers arranged directly one above another, and
wherein the sequence is formed from a first electrode layer (4), the first piezoelectric layer (2), the second piezoelectric layer (3) and a second electrode layer (5) adjacent to the first electrode layer.

10. Piezoelectric component according to either of Claims 8 and 9,
wherein the stack (1) has further first piezoelectric layers (2', 2", 2"'), and the at least one second piezoelectric layer (3).

11. Piezoelectric component according to any of Claims 8 to 10,
wherein the stack has an identical number of first and second piezoelectric layers (2, 2', 2", 2"', 3, 3', 3" 3"').

12. Piezoelectric component
comprising a stack (1) of piezoelectric layers (2, 2', 2", 2"', 3, 3', 3", 3"') arranged one above another and first and second electrode layers (4, 5) arranged therebetween,
wherein the stack (1) has at least one first piezoelectric layer (2) having a first electric coercive field strength and, directly adjacent thereto, at least one second piezoelectric layer (3) having a second electric coercive field strength different than the first coercive field strength,
wherein the first piezoelectric layer (2) and the second piezoelectric layer (3) comprise different ceramic materials, different dopants, different dopant concentrations, different particle sizes of starting materials, different layer thicknesses or a combination thereof, **characterized in that**
the first piezoelectric layer (2) has a first thickness and the second piezoelectric layer has a second thickness,
the first and second thicknesses are different from one another, and
the ratio of the first and second thicknesses is greater than or equal to 1.1 and less than or equal to 3.0.

## Revendications

1. Composant piézoélectrique présentant
un empilement (1) constitué de couches piézoélectriques (2, 2', 2", 2"', 3, 3', 3", 3"') disposées les unes au-dessus des autres et entre lesquelles sont disposées des premières et des deuxièmes couches d'électrode (4, 5),
l'empilement (1) présentant au moins une première couche piézoélectrique (2) dotée d'une première intensité de champ électrique coercitif et à son voisinage direct au moins une deuxième couche piézoélectrique (3) dotée d'une deuxième intensité de champ électrique coercitif différente de la première intensité de champ coercitif,
la première couche piézoélectrique (2) et la deuxième couche piézoélectrique (3) présentant des matériaux céramiques différents, des substances de dopage différentes, des concentrations différentes en substances de dopage, des tailles des particules de matériau de départ différentes, des épaisseurs différentes ou une de leurs combinaisons,
la première et la deuxième couche piézoélectrique (2, 3) présentant un matériau céramique formé de plusieurs composants présentant des concentrations respectives,
la concentration d'au moins un composant de la première et des deuxièmes couches piézoélectriques (2, 3) étant différente,
la première et la deuxième couche piézoélectriques (2, 3) présentant un matériau céramique doté des mêmes composants,
le matériau céramique présentant en fonction de la concentration d'au moins un premier composant une limite de phase morphotrope située entre une première structure et une deuxième structure du matériau céramique,
la concentration du premier composant du matériau céramique de la première et de la deuxième couche piézoélectrique (2, 3) étant sélectionnée de telle sorte que la première couche piézoélectrique (2) présente le matériau céramique de la première structure et la deuxième couche piézoélectrique (3) le matériau céramique de la deuxième structure.

2. Composant piézoélectrique selon la revendication précédente, dans lequel la première et la deuxième couche piézoélectrique (2, 3) sont sélectionnées de telle sorte qu'une frontière de contact (6) entre les deux couches forme une zone de formation de fissures de délestage et/ou de polarisation qui s'étendent essentiellement en parallèle aux couches d'électrode (4, 5).

3. Composant piézoélectrique selon la revendication précédente, dans lequel la première et la deuxième couche piézoélectrique (2, 3) se distinguent par exactement une propriété sélectionnée parmi différents matériaux céramiques, différentes substances de dopage, différentes concentrations de substances de dopage, des tailles de particules de matériau de départ différentes et différentes épaisseurs de couche.

4. Composant piézoélectrique selon l'une des revendications précédentes, dans lequel la première et la deuxième couches piézoélectriques (2, 3) présentent des matériaux céramiques réalisés à partir de poudres de départ présentant des particules de tailles différentes.

5. Composant piézoélectrique selon la revendication précédente, dans lequel la taille des particules d50 de la poudre de départ est supérieure ou égale à 0,3 µm et inférieure ou égale à 2,0 µm et dans lequel la différence entre les tailles des particules d50 des poudres de départ est supérieure ou égale à 0,1 µm et inférieure ou égale à 1,5 µm.

6. Composant piézoélectrique selon l'une des revendications précédentes, dans lequel la première couche piézoélectrique (2) présente une première épaisseur et la deuxième couche piézoélectrique une deuxième épaisseur et dans lequel la première et la deuxième épaisseur sont différentes l'une de l'autre.

7. Composant piézoélectrique selon la revendication précédente, dans lequel le rapport entre la première et la deuxième épaisseur est supérieur ou égal à 1,1 et inférieur ou égal à 3,0.

8. Composant piézoélectrique selon l'une des revendications précédentes, dans lequel l'empilement (1) présente une succession de couches disposées directement les unes au-dessus des autres et dans lequel la succession est formée d'une première couche d'électrode (4), de la première couche piézoélectrique (2), d'une deuxième couche d'électrode (5), de la deuxième couche piézoélectrique (3) et d'une autre première couche d'électrode (4).

9. Composant piézoélectrique selon l'une des revendications précédentes, dans lequel l'empilement (1) présente une succession de couches disposées directement les unes au-dessus des autres et dans lequel la succession est formée d'une première couche d'électrode (4), de la première couche piézoélectrique (2), de la deuxième couche piézoélectrique (3) et d'une deuxième couche d'électrode (5) voisine de la première couche d'électrode.

10. Composant piézoélectrique selon l'une des revendications précédentes, selon l'une des revendications 8 ou 9, dans lequel l'empilement (1) présente d'autres couches piézoélectriques (2, 2', 2", 2"') et la ou les deuxièmes couches piézoélectriques (3).

11. Composant piézoélectrique selon l'une des revendications 8 à 10, dans lequel l'empilement présente un même nombre de premières et de deuxièmes couches piézoélectriques (2, 2', 2", 2"', 3, 3', 3", 3"').

12. Composant piézoélectrique doté d'un empilement (1) constitué de couches piézoélectriques (2, 2', 2", 2"', 3, 3', 3", 3"') disposées les unes au-dessus des autres avec entre elles des premières et des deuxièmes couches d'électrode (4, 5),
l'empilement (1) présentant au moins une première couche piézoélectrique (2) dotée d'une première intensité de champ électrique coercitif et à son voisinage direct au moins une deuxième couche piézoélectrique (3) dotée d'une deuxième intensité de champ électrique coercitif différente de la première intensité de champ coercitif,
la première couche piézoélectrique (2) et la deuxième couche piézoélectrique (3) présentant différents matériaux céramiques, différentes substances de dopage, différentes concentrations en substances de dopage, des tailles de particules du matériau de départ différentes, différentes épaisseurs ou une de leurs combinaisons,
**caractérisé en ce que**
la première couche piézoélectrique (2) présente une première épaisseur et la deuxième couche piézoélectrique une deuxième épaisseur,
la première et la deuxième épaisseur étant différentes l'une de l'autre et
le rapport entre la première et la deuxième épaisseur étant supérieur ou égal à 1,1 et inférieur ou égal à 3,0.
